# EUROPEAN PATENT APPLICATION

(11) **EP 3 842 566 A1**
(43) Date of publication of application: **30.06.2021**
(21) Application number: 19383205.2
(22) Date of filing: 27.12.2019
(51) Int. Cl.: C23C 14/14, C23C 16/06, G01K 1/14, G01K 7/16, C23C 14/04, C23C 16/04

(54) **PIPE WITH RESISTANCE TEMPERATURE DETECTION SENSOR**

(71) Applicant: Tubacex Innovación A.I.E., 48160 Derio - Vizcaya (ES); Fundación Tecnalia Research & Innovation, 20009 San Sebastián, Guipúzcoa (ES)
(72) Inventor: Herrero, Diego, 48160 Vizcaya (ES); Brizuela, Marta, 20009 San Sebastián - Guipúzcoa (ES); Domínguez, Santiago, 20009 San Sebastián - Guipúzcoa (ES); Baptiste Jorcin, Jean, 20009 San Sebastián - Guipúzcoa (ES)
(74) Representative: Balder IP Law, S.L.

(57) **Abstract**

A method for providing a resistance temperature detection sensor on a pipe by means of physical vapor deposition. And a pipe comprising at least one resistance temperature detection sensor on an outer surface of the pipe, the at least one resistance temperature detection sensor at least comprising a sensor layer and a protecting layer at least on a portion of the sensor layer.

## Description

### TECHNICAL FIELD

The present invention relates to the technical field of pipes, and more particularly, it relates to pipes that have a resistance temperature detector on an outer surface thereof.

### STATE OF THE ART

Pipes are essential in many industries and applications in which transportation of fluid materials, such as liquids and gases, is necessary. Oftentimes not only the fluid material needs to be transported but also monitored while in the pipes so as to determine whether any issues with the material exist. In this respect, in order to monitor the fluid material, the temperature of the fluid material is usually a relevant parameter when making such determination.

Providing a pipe with a temperature sensor is not a simple task as it is complex to have a sensor reliably attached to the pipe and accessible enough so as to retrieve the measurements of the sensor outside of the pipe. It should be borne in mind that the flow of fluid material may exert a pressure on the sensor that detaches it from the surface of the pipe, thus the greater the flow is, the greater the pressure exerted on the sensor.

Moreover, no reduction in flow of the fluid material is desired in the pipe industry, thus limiting the flow due to the presence of a sensor is not an option in most occasions.

There have been attempts in the prior art to arrange, for example, resistance temperature detector (i.e. RTD) sensors in a gas turbine engine as described in patent document EP3404218A1, or produce a temperature sensor with a platinum thin-film resistor for providing a temperature sensor with reduced size as described in patent document US2003174041A1.

However, there is an interest in arranging a temperature sensor on a pipe for measuring the temperature fluid material flowing therein that overcomes the problems explained above.

### DESCRIPTION OF THE INVENTION

A first aspect of the invention relates to a method for providing a resistance temperature detection sensor on a pipe, the method comprising:
arranging the pipe in a vacuum chamber;
adding a sensor layer on an outer surface of the pipe by physical vapor deposition (i.e. PVD) or chemical vapor deposition (i.e. CVD) while the pipe is in the vacuum chamber; and
adding a protecting layer at least on a portion of the sensor layer by PVD or CVD while the pipe is in the vacuum chamber, or by sol-gel deposition.

The present method makes possible to provide an RTD sensor on the outer surface of the pipe so that the fluid material flowing in the pipe does not contact the sensor, thereby avoiding the detachment of the sensor due to pressure exerted by the fluid material. Further, as the RTD sensor is on the outside of the pipe, access to the sensor is simple and straightforward, thus the measurements may be retrieved without introducing any equipment within the pipe.

As it is known, the temperature measurements of an RTD sensor depend upon the variation of the electrical resistance of the material of the sensor, so when the temperature of the material changes, so does the electrical resistance of the material. Accordingly, this change in electrical resistance is measurable by the sensor, and based on the expected electrical resistance of the material (of the sensor layer), the temperature thereof can be derived.

Since the pipe comprises a curved surface on which the sensor needs to be arranged, and considering that the sensor layer must include a pattern for measuring the electrical resistance (as it is known in the technical field of RTD sensors), the sensor layer is formed by physical or chemical vapor deposition (while the pipe is in the vacuum chamber). Accordingly, one or more masks with the pattern of the sensor layer is first attached to the outer surface of the pipe for forming the sensor layer.

In order to mechanically and chemically protect the sensor layer from attacking agents due to its exposure (as it is on the outer surface of the pipe), a protecting layer is added on top of at least portion of the sensor layer. The leads of the sensor layer can be maintained without the protecting layer so that access thereto is simpler.

When the sensor layer is formed by means of PVD in some embodiments, the PVD procedure preferably comprises magnetron sputtering.

When the protecting layer is formed by means of PVD in some embodiments, the PVD procedure preferably comprises reactive magnetron sputtering, preferably also when the sensor layer is formed by means of magnetron sputtering.

In some other embodiments, the PVD procedures for forming the sensor layer and the protecting layer comprise other deposition methods like: atomic layer deposition (i.e. ALD), laser ablation; for the formation of the protecting layer by means of PVD, said PVD procedure can also be polymeric coating. In this sense, in these other cases, both the sensor layer and the protecting layer are, preferably but not necessarily, formed with the same PVD procedure. For instance, both the sensor layer and protecting layer are formed with ALD or laser ablation, or the sensor layer is formed with magnetron sputtering and the protecting layer with laser ablation, and likewise the sensor layer may be formed by means of PVD and the protecting layer may be formed by means of sol-gel deposition (in which case the pipe is not arranged in the vacuum chamber) or polymeric coating as a PVD procedure, to name few examples.

Depending on the dimensions of the vacuum chamber and the dimensions of the pipe, most notably the diameter thereof, in some cases the pipe may be arranged as a wall of the vacuum chamber.

In some embodiments, adding the sensor layer on the outer surface of the pipe comprises: attaching a first mask on the outer surface of the pipe, the first mask comprising a first portion of a pattern of the sensor layer; forming a first portion of the pattern of the sensor layer by PVD or CVD while the pipe is in the vacuum chamber and the first mask is attached thereto; detaching the first mask and attaching a second mask on the outer surface of the pipe, the second mask comprising a second portion of the pattern of the sensor layer, and the second mask being attached to the pipe such that the second portion of the pattern connects with the first portion of the pattern formed on the sensor layer; and forming a second portion of the pattern of the sensor layer by PVD or CVD while the pipe is in the vacuum chamber and the second mask is attached thereto.

The sensor layer is preferably added using PVD or CVD by means of at least two masks that, preferably, are flexible so as to be attachable on the outer surface of the pipe in spite of the curvature thereof. If a single mask is used, at least some segments of the pattern of the sensor layer could not be formed properly so that a continuum exists over the entire pattern and with a width of the pattern appropriate for measuring the electrical resistance.

Therefore, segments having similar orientations (that is to say, segments that form angles between them that, in absolute value, are less than 45°, more preferably less than 30°, and more preferably less than 15°) are provided in a same mask so that said segments are formed on the outer surface by means of the PVD or CVD procedure with appropriate thickness. In order to form the complete pattern, when the second mask is attached to the outer surface for forming the at least second segments (the at least first segments being formed by means of the first mask), the second mask must be attached such that the segments of the second pattern connect with those already formed on the outer surface of the pipe (namely, the segments of the first pattern), in this way the complete pattern is formed after the at least second PVD or CVD procedure.

The formation of both patterns is carried out with the same procedure, thus either PVD or CVD. In the embodiments in which PVD is used, preferably the PVD comprises magnetron sputtering.

In some embodiments, the method further comprises, prior to adding the sensor layer, adding at least one electrically isolating layer at least in a portion of the outer surface of the pipe where the sensor layer is to be added, and the at least one electrically isolating layer being added by PVD or CVD while the pipe is in the vacuum chamber, or by sol-gel deposition, or by thermal spraying.

One or more electrically isolating layers are to be added between the sensor layer and the outer surface of the pipe. In this way, when at least the outer surface of the pipe is electrically conductive (due to the material of the pipe and no coatings thereon that are electrically non-conductive), the currents on the sensor layer do not transfer to the outer surface of the pipe, something that would render the sensor unusable. When the electrically isolating layer or layers are provided, the temperature of the sensor layer also changes in accordance with the temperature of the pipe and the fluid material flowing therein, thus by measuring the electrical resistance of the sensor layer, the temperature can be determined.

The provision of the at least one electrically isolating layer is necessary whenever an electrical resistance of the sensor layer (that is to say, of the material of the sensor layer) is higher than an electrical resistance of the outer surface of the pipe (that is to say, of the material of the outer surface of the pipe).

Preferably, the at least one electrically isolating layer added has a thickness of 2 microns or more, e.g. 3 microns, 50 microns, or more than 50 microns, and preferably is equal to or less than 250 microns, e.g. 200 microns or less, 100 microns or less, etc.

When the at least one electrically isolating layer is formed by means of PVD in some embodiments, the PVD procedure preferably comprises reactive magnetron sputtering.

In some other embodiments, the PVD procedure comprises other deposition method, for example ALD or laser ablation.

When sol-gel deposition or thermal spraying is used for the formation of the at least one electrically isolating layer, the pipe is not arranged in the vacuum chamber during the forming procedure of said electrically insulating layer(s).

In some embodiments, the pipe comprises an electrically conductive material. In some of these embodiments, the pipe comprises a metallic or alloy material, such as, for example steel, copper, nickel, aluminum, titanium, etc. In some of these embodiments, the outer surface of the pipe comprises the electrically conductive material, i.e. the outer surface is not coated with an electrically non-conductive material such as e.g. a ceramic coating.

In the context of the present of disclosure, preferably a material is considered to be electrically conductive if its conductivity at room temperature (e.g. 20°C) is equal to or greater than 1,0 . 10⁴ Sm⁻¹. In some embodiments, the at least one electrically isolating layer comprises one or more of: Al₂O₃, AlN, SiO₂, Si₃N₄, and ZrO₂. Accordingly, the at least one electrically isolating layer may have one of these compounds or more than one of these compounds, thus combinations thereof.

In some embodiments, the method further comprises, prior to arranging the pipe in the vacuum chamber, ultrasonically cleaning at least a portion of the outer surface of the pipe where the sensor layer is to be added. In some of these embodiments, the ultrasonic cleaning at least lasts 15 minutes. In some of these embodiments, the ultrasonic cleaning is carried out in ethanol.

The ultrasonic cleaning prepares the outer surface of the pipe for providing the RTD sensor thereon so that it remains reliably attached and avoid the appearance of defects, thereby increasing the useful life of the sensor.

In some embodiments, the method further comprises, prior to ultrasonically cleaning, cleaning at least a portion of the outer surface of the pipe where the sensor layer is to be added with acetone and/or ethanol.

For example, at least said portion can be cleaned with acetone first, using a wipe for instance, and then cleaned with ethanol. Afterwards, the ultrasonic cleaning is carried out.

In some embodiments, the method further comprises, prior to ultrasonically cleaning: turning at least a portion of the outer surface of the pipe where the sensor layer is to be added; and after the turning, blasting a mineral at least on a portion of the outer surface of the pipe where the sensor layer is to be added.

Both the turning, which is preferably soft turning, and the mineral blasting, which is preferably a soft blasting, prepare the surface of the pipe for providing the RTD sensor thereon. Therefore, if the surface of the pipe is rough or wrinkled, the turning and the mineral blasting make the surface smoother.

After the mineral blasting, the surface can be cleaned with acetone and/or ethanol, or the ultrasonic cleaning is carried out.

In some embodiments, the mineral is a mineral with a hardness equal to or greater than a hardness of the pipe. In some of these embodiments, the mineral is ceramic. In some of these embodiments, the mineral comprises white corundum.

The use of a mineral of such hardness enhances the surface of the pipe for providing the RTD sensor. It has been found out that ceramic minerals such as e.g. white corundum (for example, F220 white corundum) result in good adhesion of the different layers of the sensor.

In some embodiments, the sensor layer comprises one of the following: platinum, nickel and copper.

In some embodiments, the protecting layer comprises one or more of: Al₂O₃, AlN, SiO₂, Si₃N₄, and ZrO₂. Accordingly, the protecting layer may have one of these compounds or more than one of these compounds, thus combinations thereof.

In some embodiments, a plurality of RTD sensors are provided on the pipe by adding a plurality of sensor layers on the outer surface of the pipe. In some of these embodiments, the same protecting layer is at least added on the plurality of sensor layers, or a plurality of protecting layers is added by physical vapor deposition. In some of these embodiments, the at least one electrically isolating layer is at least in portions of the outer surface of the pipe where the plurality of sensor layers is to be added.

For the addition of the plurality of sensor layers, the first mask and the second mask may be adapted for forming the complete pattern of each sensor layer, in this way, the two PVD procedures form the plurality of sensor layers.

In some embodiments, an outer diameter of the pipe is equal to or less than 4 meters. In some of these embodiments, the outer diameter is equal to or less than 2,5 m.

In some embodiments, an outer diameter of the pipe is equal to or greater than 20 mm.

A second aspect of the invention relates to a pipe obtained or obtainable with a method according to the first aspect of the invention.

A third aspect of the invention relates to a pipe comprising a resistance temperature detection sensor on an outer surface of the pipe, the resistance temperature detection sensor at least comprising a sensor layer and a protecting layer at least on a portion of the sensor layer.

The pipe, which is preferably obtained or obtainable with a method according to the first aspect of the invention, comprises an RTD sensor on the outer surface thereof that makes possible to determine the temperature thereof by measuring the electrical resistance of the sensor layer; to this end, the sensor layer of the sensor comprises an RTD pattern as known in the art. From that measurement, it is possible to determine the temperature of the fluid material within the pipe, as the temperature thereof will change the temperature of the pipe, thereby changing the temperature of the sensor layer and, thus, the electrical resistance of the sensor layer, the latter being measured by the sensor.

In some embodiments, the resistance temperature detection sensor further comprises at least one electrically insulating layer between the outer surface of the pipe and the sensor layer. In some of these embodiments, the pipe comprises an electrically conductive material, e.g. steel, copper, nickel, aluminum, titanium, alloy, etc. In some of these embodiments, the outer surface of the pipe comprises the electrically conductive material.

Similar advantages as those described with reference to the first aspect of the invention may also apply to the second aspect of the invention.

### BRIEF DESCRIPTION OF THE DRAWINGS

To complete the description and in order to provide for a better understanding of the invention, a set of drawings is provided. Said drawings form an integral part of the description and illustrate embodiments of the invention, which should not be interpreted as restricting the scope of the invention, but just as examples of how the invention can be carried out. The drawings comprise the following figures:
Figures 1A-1B show different views of a pipe in accordance with an embodiment, and Figure 1C shows a section of the resistance temperature detection sensor of the pipe.
Figures 2A-2B show a procedure for adding a sensor layer in methods in accordance with embodiments.
Figure 3 shows a pipe with a sensor formed thereon in accordance with embodiments.
Figure 4 shows, in block diagram form, a method in accordance with embodiments.
Figure 5 shows, in block diagram form, a procedure for adding a sensor layer in methods in accordance with embodiments.
Figure 6 shows, in block diagram form, a method in accordance with embodiments.

### DESCRIPTION OF WAYS OF CARRYING OUT THE INVENTION

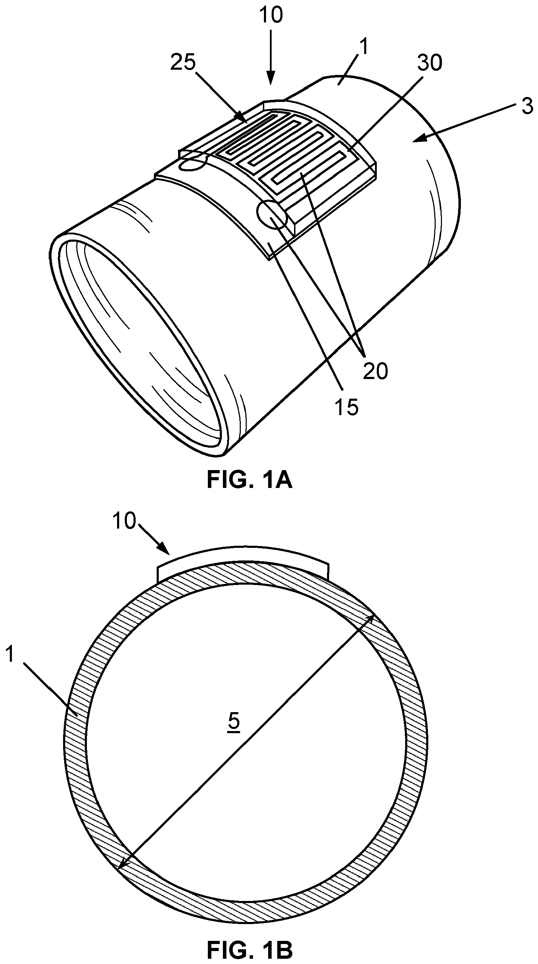

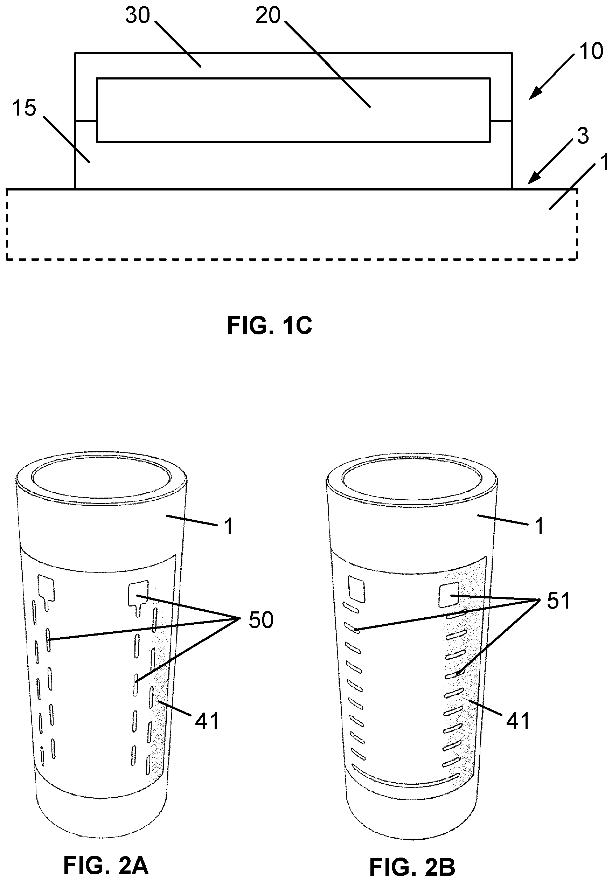

Figures 1A-1B show different views of a pipe 1 in accordance with an embodiment, and Figure 1C shows a section of the resistance temperature detection sensor 10 of the pipe 1.

The pipe 1, which has an outer diameter 5, has at least one RTD sensor 10 provided on an outer surface 3 thereof. The RTD sensor 10 includes at least one electrically insulating layer 15 on the outer surface 3 of the pipe 1, a sensor layer 20 on the at least one electrically insulating layer 15, and a protecting layer 30 on a portion of the sensor layer 20 (in this example, the leads or terminals of the sensor layer 20 are not covered by the protecting layer 30) where the RTD pattern 25 of the sensor layer 20 is.

As better seen in Figure 1C, the RTD sensor 10 has the electrically insulating layer 15 between the sensor layer 20 and the outer surface 3 of the pipe 1 so that, if the pipe 1 is of an electrically conductive material e.g. steel (and no electrically non-conductive coatings are on the outer surface 3), the currents in the sensor layer 20 are not transferred to the outer surface 3. The RTD sensor 10 has the protecting layer 30 on top of the sensor layer 20.

The pipe 1 may be of an electrically non-conductive material, in which case the RTD sensor 10 may or may not have the at least one electrically insulating layer 15. Such material could be, for instance, a ceramic material, a polymeric material, or a combination of a ceramic material and a polymeric material.

Figures 2A-2B show a procedure for adding a sensor layer in methods in accordance with embodiments.

In Figure 2A there is shown a pipe 1 during the procedure for providing an RTD sensor thereon (for instance a sensor as shown in Figures 1A-1C). The pipe 1 has a mask 40 thereon that includes segments 50 of a portion of the pattern to be formed in the sensor layer. The segments 50 have a same direction (but in other examples different segments have different directions, but preferably the angle formed between each pair of segments is not greater than 45°), in this case vertical direction according to the illustration, and during a PVD procedure like, preferably, magnetron sputtering, or a CVD procedure, the material of the sensor layer will attach to the pipe 1 according to these segments 50.

After forming these first segments 50 on the pipe 1, the mask 40 is detached and another mask 41, as illustrated in Figure 2B, is attached to the pipe 1 for completing the pattern. This another mask 41 includes segments 51 with a direction that is perpendicular to the segments 50 of the first mask 40, and are arranged on the another mask 41 such that the combination of both pluralities of segments 50, 51 results in the complete pattern of the sensor layer. Accordingly, this another mask 41 has to be attached to the pipe 1 taking into account the existing segments formed on the pipe 1 owing to the first mask 40 and the PVD or CVD procedure.

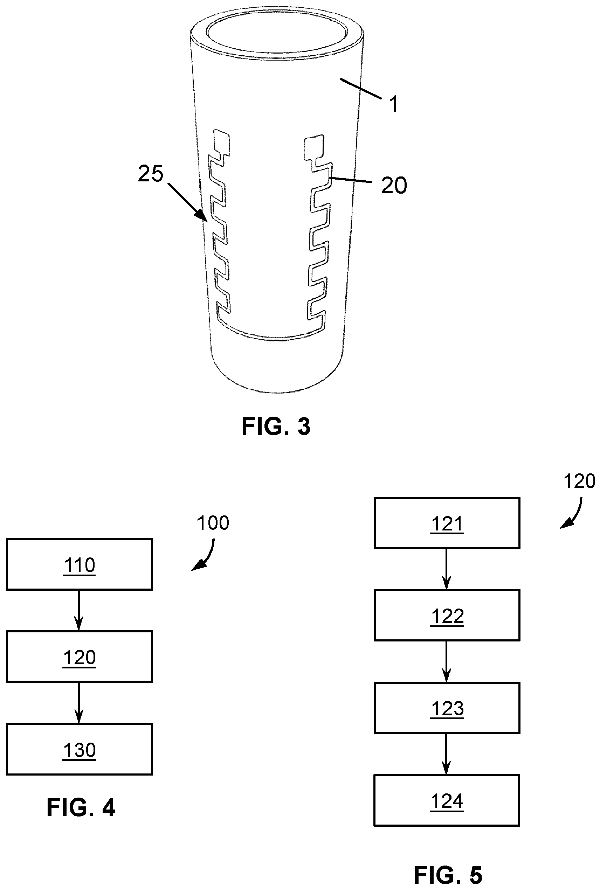

After the PVD or CVD procedure, the complete RTD pattern 25 of the sensor layer is formed on the pipe 1, which is illustrated in Figure 3.

As it can be seen in both Figures 2A and 2B, the masks 40, 41 are flexible enough to attach on the outer surface of the pipe despite the curvature of the pipe 1.

Even though in this example two masks 40, 41 have been shown for forming the sensor layer, in other examples more than two masks may be necessary to form the sensor layer in a PVD or CVD procedure so that the pattern of the sensor layer is correctly provided (i.e. all the segments connected and with appropriate width of the segments). The provision of further masks may depend upon any one of the curvature of the outer surface of the pipe 1, the pattern of the sensor layer, and the flexibility of the masks.

Figure 4 shows, in block diagram form, a method 100 in accordance with embodiments.

The method 100 includes a step 110 of arranging a pipe in a vacuum chamber.

The method 100 further includes a step 120 of adding a sensor layer (such as, for instance, the sensor layer 20 of any one of Figures 1A-1C and 3) on an outer surface of the pipe by means of physical vapor deposition or chemical vapor deposition when the pipe is arranged 110 in the vacuum chamber. In some embodiments, the addition of the sensor layer is carried out by means of the procedure described with reference to Figure 5.

When the sensor layer is added 120 by way of CVD, preferably the CVD process is one of: laser chemical vapor deposition (i.e. LCVD), plasma-enhanced chemical vapor deposition (PECVD), and low pressure chemical vapor deposition (i.e. LPCVD).

The method 100 further includes, once the sensor layer has been added 120, a step 130 of adding a protecting layer at least on a portion of the sensor layer. The protecting layer can be formed by physical vapor deposition or chemical vapor deposition while the pipe is arranged 110 in the vacuum chamber. Alternatively, the protecting layer can be formed by sol-gel deposition without the pipe being arranged in the vacuum chamber, or it can also be formed by polymeric coating.

When the protective layer is added 130 by way of CVD, preferably the CVD process is one of: laser chemical vapor deposition (i.e. LCVD), plasma-enhanced chemical vapor deposition (PECVD), low pressure chemical vapor deposition (i.e. LPCVD), and polymeric coating.

Figure 5 shows, in block diagram form, a procedure 120 for adding a sensor layer in a method in accordance with an embodiment.

The procedure 120 includes a step 121 of attaching a first mask (for example, the mask 40 of Figure 2A) on the outer surface of the pipe. The first mask has a first portion of a pattern of the sensor layer.

The procedure 120 includes a step 122 of forming the first portion of the pattern of the sensor layer by PVD or CVD, thus the pipe is in the vacuum chamber and the first mask is attached 121 thereto while the pipe is subjected to PVD or CVD.

The procedure 120 includes a step 123 of detaching the first mask and attaching a second mask (for example, the mask 41 of Figure 2B) on the outer surface of the pipe. The second mask has a second portion of the pattern of the sensor layer. The second mask must be attached to the outer surface of the pipe such that the second portion of the RTD pattern connects with the first portion of the pattern that has been formed in the previous step 122.

The procedure 120 includes a step 124 of forming the second portion of the pattern of the sensor layer by PVD or CVD, thus the pipe is in the vacuum chamber and the second mask is attached 123 thereto while the pipe is subjected to PVD or CVD.

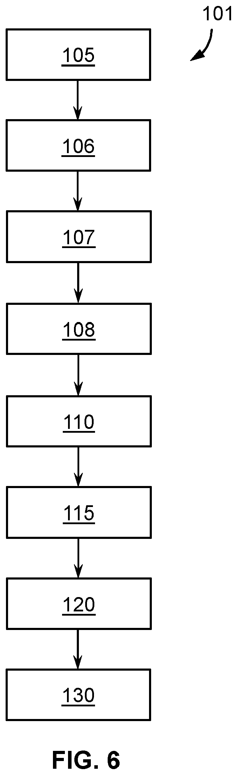

Figure 6 shows, in block diagram form, a method 101 in accordance with embodiments.

The method 101 includes a step 105 of turning at least a portion of an outer surface of a pipe where a sensor layer is to be added later on.

The method 101 further includes a step 106 of blasting a mineral at least on a portion of the outer surface of the pipe where the sensor layer is to be added. The blasting 106 is carried out after the turning 105.

The method 101 further includes, after the mineral blasting 106, a step 107 of cleaning at least a portion of the outer surface of the pipe where the sensor layer is to be added with acetone and/or ethanol. For instance, the surface is first cleaned with acetone, and then with ethanol. To this end, a wipe may be used for cleaning the surface with such product or products.

The method 101 further includes a step 107 of cleaning at least a portion of the outer surface of the pipe where the sensor layer is to be added with acetone and/or ethanol. For instance, the surface is first cleaned with acetone, and then with ethanol. To this end, a wipe may be used for cleaning the surface with such product or products.

The method 101 further includes, after the cleaning 107, a step 108 of ultrasonically cleaning at least a portion of the outer surface of the pipe where the sensor layer is to be added. A product such as e.g. ethanol may be used in the ultrasonic cleaning.

The method 101 further includes, after the ultrasonic cleaning 108, the step 110 of arranging the pipe in a vacuum chamber.

The method 101 further includes a step 115 of adding at least one electrically isolating layer (such as, for instance, the electrically isolating layer 10 of Figures 1A-1C) at least in a portion of the outer surface of the pipe where the sensor layer is to be added. The layer or layers are added 115 by means of PVD or CVD once the pipe has been arranged 110 in the vacuum chamber. Alternatively, the addition 115 of the at least one electrically isolating layer can be carried out by means of sol-gel deposition or thermal spraying, in which case the addition 115 of the layer or layers is carried out before arranging 110 the pipe in the vacuum chamber.

When the at least one electrically isolating layer is added 115 by way of CVD, preferably the CVD process is one of: laser chemical vapor deposition (i.e. LCVD), plasma-enhanced chemical vapor deposition (PECVD), and low pressure chemical vapor deposition (i.e. LPCVD).

The method 101 further includes the step 120 of adding a sensor layer as described, for instance, with reference to Figure 4 and/or Figure 5.

The method 101 further includes, once the sensor layer has been added 120, the step 130 of adding a protecting layer as described, for instance, with reference to Figure 4.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. A method (100, 101) for providing a resistance temperature detection sensor (10) on a pipe (1), the method comprising:
arranging (110) the pipe (1) in a vacuum chamber;
adding (120) a sensor layer (20) on an outer surface (3) of the pipe (1) by physical vapor deposition or chemical vapor deposition while the pipe (1) is in the vacuum chamber; and
adding (130) a protecting layer (30) at least on a portion of the sensor layer (20) by physical vapor deposition or chemical vapor deposition while the pipe (1) is in the vacuum chamber.

2. The method (100, 101) of claim 1, wherein adding (120) the sensor layer (20) on the outer surface (3) of the pipe (1) at least comprises:
attaching (121) a first mask (40) on the outer surface (3) of the pipe (1), the first mask (40) comprising a first portion (50) of a pattern (25) of the sensor layer (20);
forming (122) a first portion of the pattern (25) of the sensor layer (20) by physical vapor deposition while the pipe (1) is in the vacuum chamber and the first mask (40) is attached thereto;
detaching the first mask (40) and attaching (123) a second mask (41) on the outer surface (3) of the pipe (1), the second mask (41) comprising a second portion (51) of the pattern (25) of the sensor layer (20), and the second mask (41) being attached to the pipe (1) such that the second portion (51) of the pattern (25) connects with the first portion of the pattern (25) formed on the sensor layer (20); and
forming (124) a second portion of the pattern (25) of the sensor layer (20) by physical vapor deposition while the pipe (1) is in the vacuum chamber and the second mask (41) is attached thereto.

3. The method (100, 101) of any one of the preceding claims, further comprising, prior to adding (120) the sensor layer (20), adding (115) at least one electrically isolating layer (10) at least in a portion of the outer surface (3) of the pipe (1) where the sensor layer (20) is to be added, wherein the at least one electrically isolating layer (10) is added by physical vapor deposition or chemical vapor deposition while the pipe (1) is in the vacuum chamber, or by sol-gel deposition, or by thermal spraying.

4. The method (100, 101) of claim 3, wherein the at least one electrically isolating layer (10) is added (115) by physical vapor deposition, said physical vapor deposition comprising one of:
reactive magnetron sputtering, atomic layer deposition, and laser ablation.

5. The method (100, 101) of claim 4, wherein:
the at least one electrically isolating layer (10) is added (115) by reactive magnetron sputtering;
the sensor layer (20) is added (120) by magnetron sputtering; and
the protective layer (30) is added (130) by reactive magnetron sputtering.

6. The method (100, 101) of any one of claims 3-5, wherein the pipe (1) comprises an electrically conductive material.

7. The method (100,101) of any one of claims 3-6, wherein the at least one electrically isolating layer (10) comprises one or more of: Al₂O₃, AlN. SiO₂, Si₃N₄, and ZrO₂; and the at least one electrically isolating layer (10) preferably has a thickness between 2,0 microns and 250 microns.

8. The method (100, 101) of any one of the preceding claims, further comprising, prior to arranging (110) the pipe (1) in the vacuum chamber, ultrasonically cleaning (108) at least a portion of the outer surface (3) of the pipe (1) where the sensor layer (20) is to be added, preferably at least during 15 minutes.

9. The method (100, 101) of any one of the preceding claims, wherein the protecting layer (30) is added (130) by physical vapor deposition, said physical vapor deposition comprising one of: reactive magnetron sputtering, atomic layer deposition, and laser ablation.

10. The method (100, 101) of any one of the preceding claims, wherein the sensor layer (20) is added (120) by physical vapor deposition, said physical vapor deposition comprising: magnetron sputtering, atomic layer deposition, and laser ablation.

11. A pipe (1) comprising at least one resistance temperature detection sensor (10) on an outer surface (3) of the pipe (1), the at least one resistance temperature detection sensor (10) at least comprising a sensor layer (20) and a protecting layer (30) at least on a portion of the sensor layer (20).

12. The pipe (1) of claim 11, wherein the at least one resistance temperature detection sensor (10) further comprises an electrically insulating layer (10) between the outer surface (3) of the pipe (1) and the sensor layer (20), and wherein the pipe (1) comprises an electrically conductive material.

13. The pipe (1) of any one of claims 11-12, or the method (100, 101) of any one of claims 1-10, wherein the sensor layer (20) comprises one of the following: platinum, nickel and copper.

14. The pipe (1) of any one of claims 11-13, or the method (100, 101) of any one of claims 1-10 or 13, wherein the protecting layer (30) comprises one or more of: Al₂O₃, AlN. SiO₂, Si₃N₄, and ZrO₂.

15. The pipe (1) of any one of claims 11-14, or the method (100, 101) of any one of claims 1-11 or 13-14, wherein an outer diameter (5) of the pipe (1) is equal to or less than 4 m.
